(19) Europäisches Patentamt / European Patent Office / Office européen des brevets

(11) **EP 2 270 891 A1**

(12) **EUROPEAN PATENT APPLICATION**
published in accordance with Art. 153(4) EPC

(43) Date of publication:
**05.01.2011 Bulletin 2011/01**

(51) Int Cl.:
*H01L 35/22* (2006.01)  *C04B 35/00* (2006.01)

(21) Application number: **09729825.1**

(22) Date of filing: **10.04.2009**

(86) International application number:
**PCT/JP2009/057714**

(87) International publication number:
**WO 2009/125875 (15.10.2009 Gazette 2009/42)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **10.04.2008 JP 2008102178**

(71) Applicant: **Sumitomo Chemical Company, Limited Tokyo 104-8260 (JP)**

(72) Inventors:
• **SADAOKA, Kazuo**
  **Toyonaka-shi**
  **Osaka 561-0802 (JP)**

• **HIROYAMA, Yuichi**
  **Tsukuba-shi**
  **Ibaraki 300-2617 (JP)**
• **SAWABE, Yoshinari**
  **Tsukuba-shi**
  **Ibaraki 300-4232 (JP)**

(74) Representative: **Hart-Davis, Jason et al**
  **Cabinet Beau de Loménie**
  **158, rue de l'Université**
  **75340 Paris Cedex 07 (FR)**

(54) **SINTERED COMPACT AND THERMOELECTRIC CONVERSION MATERIAL**

(57)     Disclosed are a sintered body and a thermoelectric conversion material. The sintered body comprises a manganese-based oxide as a main component, further comprises an oxide A wherein the oxide A represents one or more members selected from among nickel oxides, copper oxide and zinc oxide, and has a relative density of 80% or more and 90% or less.

EP 2 270 891 A1

**Description**

TECHNICAL FIELD

The present invention relates to a sintered body and a thermoelectric conversion material. More particularly, the present invention relates to a sintered body comprising a manganese-based oxide, and to a thermoelectric conversion material.

BACKGROUND ART

Sintered bodies comprising a manganese-based oxide are utilized in various fields such as magnetic materials, solid oxides for fuel cells and thermoelectric conversion materials.

A manganese-based oxide includes $CaMnO_3$. JP-A No. 2003-142742 (Examples) discloses to use this as a thermoelectric conversion material and specifically discloses that a $CaMnO_3$ powder is pulverized, molded and then sintered in atmospheric air at 1550°C to yield a sintered body of a manganese-based oxide.

DISCLOSURE OF THE INVENTION

However, the sintered body obtained above has a problem that cracks are generated in the sintered body when applying pressure such as processing thereof, that is, mechanical strength thereof is not sufficient. The present invention has an object of providing a sintered body superior also in mechanical strength, without deteriorating properties as a thermoelectric conversion material, as compared with sintered bodies of a conventional manganese-based oxide.

The present inventors have variously investigated and resultantly completed the present invention. That is, the present invention provides the following inventions.

<1> A sintered body comprising a manganese-based oxide as a main component, further comprising an oxide A wherein the oxide A represents one or more members selected from among nickel oxides, copper oxide and zinc oxide, and having a relative density of 80% or more and 90% or less.

<2> The sintered body according to <1>, wherein the manganese-based oxide has a perovskite type crystal structure or a layered perovskite type crystal structure.

<3> The sintered body according to <1> or <2>, wherein the manganese-based oxide comprises calcium.

<4> The sintered body according to any one of <1> to <3>, wherein the oxide A is copper oxide.

<5> the sintered body according to <4>, wherein the ratio of the molar amount of the copper oxide to one mol of the manganese-based oxide is 0.0001 or more and 0.25 or less.

<6> A thermoelectric conversion material composed of the sintered body according to any one of <1> to <5>.

<7> A thermoelectric converting device comprising the thermoelectric conversion material according to <6>.

MODE FOR CARRYING OUT THE INTENTION

The sintered body of the present invention comprises a manganese-based oxide as a main component, further comprises an oxide A wherein the oxide A represents one or more members selected from among nickel oxides, copper oxide and zinc oxide, and has a relative density of 80% or more and 90% or less.

The manganese-based oxide means an oxide comprising manganese, and "comprising a manganese-based oxide as a main component" means that the amount of a manganese-based oxide in a sintered body is 50 mol% or more. This can be determined by powder X-ray diffractometry, composition analysis and the like of a sintered body.

The manganese-based oxide includes an oxide represented by $EMnO_3$ wherein E represents one or more elements selected from the group consisting of Ca, Sr, Ba, La, Y and lanthanoid, $Ca_{n+1}Mn_nO_{3n+1}$ wherein n represents an integer of from 1 to 10), $CaMn_7O_{12}$, $Mn_3O_4$, $MnO_2$ or $CuMnO_2$. It is preferable that the manganese-based oxide have a perovskite type crystal structure or a layered perovskite crystal structure for further enhancing a thermoelectric converting property. It is preferable that the manganese-based oxide comprise calcium.

The manganese-based oxide having a perovskite type crystal structure specifically includes an oxide represented by $CaMnO_3$ (here, Ca and/or Mn may be partially substituted by heterogeneous elements). The heterogeneous element for partially substituting Ca includes Mg, Sr, Ba, Sc, Y, La, Ce, Pr, Nd, Sm, Eu, Gd, Tb, Dy, Ho, Er, Tm, Yb, Lu, Bi, Sn, In and Pb, and preferably Mg, Sr and Ba. These may be singly or in combination. The heterogeneous element for partially substituting Mn includes V, Ru, Nb, Mo, W and Ta. These may be singly or in combination. A thermoelectric conversion material comprising a sintered body of an oxide represented by $CaMnO_3$ in which Ca and/or Mn is partially substituted by heterogeneous elements has an improved thermoelectric converting property.

The manganese-based oxide having a layered perovskite type crystal structure specifically includes an oxide represented by the formula (1):

$$Ca_{n+1}Mn_nO_{3n+1} \qquad (1)$$

wherein n represents an integer of from 1 to 10, and Ca and/or Mn may be partially substituted by heterogeneous elements.

The heterogeneous element for partially substituting Ca in the formula (1) includes Mg, Sr, Ba, Sc, Y, La, Ce, Pr, Nd, Sm, Eu, Gd, Tb, Dy, Ho, Er, Tm, Yb, Lu, Bi, Sn, In and Pb, and preferably Mg, Sr and Ba. These may be singly or in combination. The heterogeneous element for partially substituting Mn includes V, Ru, Nb, Mo, W and Ta. These may be singly or in combination. A thermoelectric conversion material comprising a sintered body of an oxide represented by the formula (1) in which Ca and/or Mn is partially substituted by heterogeneous elements has an improved thermoelectric converting property.

The sintered body comprises an oxide A wherein the oxide A represents one or more members selected from among nickel oxides, copper oxide and zinc oxide. The oxide A is preferably copper oxide. By using copper oxide as the oxide A, the sintering temperature in producing a sintered body can be further lowered, and a thermoelectric conversion material having an improved thermoelectric converting property is obtained. When the oxide A is copper oxide, the ratio of the molar amount of the copper oxide to one mol of a manganese-based oxide comprised in a sintered body is preferably 0.0001 or more and 0.25 or less, more preferably 0.01 or more and 0.05 or less.

The relative density of the sintered body is 80% or more and 90% or less. When less than 80%, a thermoelectric converting property is deteriorated in some cases. While when over 90%, weight reduction of a thermoelectric converting device becomes difficult, its thermal conductivity increases, and its thermoelectric converting property lowers. The sintered body can be used in a shape suitable for each application, such as plate, circular cylinder, and rectangular cylinder. The relative density is determined by the following formula where the formula weight of a manganese-based oxide in a sintered body is represented by $\alpha_1$, the theoretical density of a manganese-based oxide is represented by $\beta_1$ (g/cm$^3$), the atomic weight of an oxide A is represented by $\alpha_2$, the theoretical density of an oxide A is represented by $\beta_2$ (g/cm$^3$), the actually measured density of a sintered body is represented by Y (g/cm$^3$), and the ratio of an oxide A in a sintered body is represented by x (mol%):

$$\text{Relative density (\%)} = Y/[\{\alpha_1 \times (100-x) + \alpha_2 \times x\}/\{\alpha_1 \times (100-x)/\beta_1 + \alpha_2 \times x/\beta_2\}] \times 100.$$

Next, a method of producing a sintered body will be described.

A sintered body can be produced by sintering a molded body comprising a manganese-based oxide and an oxide A wherein the oxide A has the same meaning as described above. By use of this molded body, the uniformity of the composition of a sintered body and the uniformity of the structure of a sintered body can be improved and the deformation of a sintered body can be suppressed, thus, the mechanical strength of a sintered body can be further improved.

Sintering may be carried out under normal pressure, and pressure sintering using hot press or pulse current sintering may also be carried out. The sintering atmosphere is an oxidizing atmosphere in a preferable embodiment. This atmosphere includes an air atmosphere or an atmosphere comprising 20 vol% or more of oxygen. The atmosphere comprising 20 vol% or more of oxygen includes an oxygen atmosphere, and a mixed gas atmosphere of oxygeninert gas (oxygen-nitrogen, oxygen-argon, etc.). The sintering atmosphere may also be an inert atmosphere. The inert atmosphere includes atmospheres composed of an inert gas such as nitrogen and argon. The inert atmosphere may comprise oxygen in an approximate amount not generating an oxidizing atmosphere (for example, the oxygen concentration is less than about 20 vol%). It is also possible, after sintering in such an inert atmosphere, to perform annealing in an oxidizing atmosphere, thereby controlling the oxygen amount in a sintered body. Moreover, the resultant sintered body may be pulverized, and sintering may be carried out again using the pulverized substance.

The above-described molded body can be obtained, for example, by any of the following methods (a) to (d).

(a) A manganese-based oxide and an oxide A are mixed, and then molded to yield a molded body.
(b) A manganese-based oxide and a raw material of an oxide A are mixed, then calcined, and molded to yield a molded body.
(c) A raw material of a manganese-based oxide and an oxide A are mixed, then calcined, and molded to yield a molded body.

(d) A raw material of a manganese-based oxide and a raw material of an oxide A are mixed, then calcined, and molded to yield a molded body.

The manganese-based oxide can be obtained by calcining a raw material of a manganese-based oxide. The raw material of a manganese-based oxide can be obtained usually by weighing compounds comprising metal elements constituting a manganese-based oxide so as to give a prescribed composition, and mixing them. In the above-described case (c) or (d), other materials (specifically, an oxide A, raw material of an oxide A) may also be mixed in the above-described mixing, before performing calcination.

As the compound comprising metal elements constituting a manganese-based oxide, for example, an oxide is used, alternatively, a compound capable of becoming a oxide when decomposed and/or oxidized at high temperatures, such as a hydroxide, a carbonate, a nitrate, a halide, a sulfate, and an organic acid salt is used. Instead of the compound, a metal comprising the above-described metal elements may be used singly. In the case of use of $CaMnO_3$ as the manganese-based oxide, constituent metal elements are Ca and Mn, and the compound comprising Ca includes a carbonate, a sulfate, a hydroxide and the like, and a carbonate is preferably used. The compound comprising Mn includes manganese monoxide, manganese dioxide, dimanganese trioxide, trimanganese tetraoxide, manganese nitrate, manganese acetate and the like, and manganese dioxide is preferably used. The raw material of a manganese-based oxide can be obtained by weighing these compounds so as to give a prescribed composition, and mixing them.

The oxide A includes one or more members selected from among nickel oxides, copper oxide and zinc oxide. The oxide A can also be obtained by calcination of a raw material of an oxide A. The raw material of an oxide A includes a nitrate, an acetate, a sulfate, a halide, an amine complex, an organic metal compound and the like. For example, when the oxide A is copper oxide, the raw material of the oxide A includes $Cu(NO_3)_2$, $CuSO_4$ and the like.

Mixing may be carried out by either a dry mixing method or a wet mixing method, and a method capable of uniformly mixing compounds comprising metal elements is preferably carried out, and in this case, examples of the mixing apparatus include apparatuses such as a ball mill, a V-shaped mixer, a vibration mill, an attritor, a dino mill and a dynamic mill. A manganese-based oxide or a raw material of a manganese-based oxide can be obtained also by a co-precipitation method, a hydrothermal method, a dry up method of evaporating an aqueous solution to dryness, a sol gel method and the like, in addition to the above-described mixing.

The above-described molding may be performed so as to give an intended shape such as a plate shape, a rectangular cylinder shape and a circular cylinder shape. The molding method can be carried out, for example, by a uniaxial press, a cold isostatic press (CIP), a mechanical press, a hot press and a hot isostatic press (HIP). The molded body may comprise a binder, a dispersant, a releasing agent and the like.

The calcination is preferably carried out in an oxidizing atmosphere. Pulverization may also be carried out, after calcination.

Calcination conditions such as a calcining temperature, a calcining atmosphere, a calcining temperature retention time and temperature rising and falling speeds in calcination and sintering conditions such as a sintering temperature, a sintering atmosphere, a sintering temperature retention time and temperature rising and falling speeds in sintering may be appropriately set depending on the kind of a manganese-based oxide and an oxide A. Each of a manganese-based oxide, a raw material of a manganese-based oxide, an oxide A, and a raw material of an oxide A is preferably in the form of particles, and powder properties (average particle diameter, specific surface area) may be appropriately set. In a sintered body, the relative density is adjusted by powder properties of a calcined substance and a molded substance, a molding pressure in molding, a sintering temperature, a sintering temperature retention time and the like, in addition to the above-described powder properties.

Next, sintered bodies in which the combination of a manganese-based oxide/an oxide A is a manganese-based oxide having a perovskite type crystal structure or a layered perovskite type crystal structure/copper oxide are exemplified, and particularly when the manganese-based oxide is $CaMnO_3$, its production method will be described.

A sintered body in which the combination of a manganese-based oxide/copper oxide is $CaMnO_3$/CuO can be produced by molding a mixture of CaMnO3 and CuO to obtain a molded body (corresponding to the above-described case (a)), and then sintering the molded body by heating up to a sintering temperature within the range of from 800°C to 1000°C. The sintering temperature retention time is 0 to 48 hours. When the sintering temperature is lower than 800°C, it is difficult for the molded body to be sintered in some cases, and when the sintering temperatures is over 1000°C, the relative density of the resultant sintered body is over 90% in some cases. The sintering atmosphere is preferably an oxidizing atmosphere. It is also possible to control the oxygen amount in a manganese-based oxide of a sintered body, by changing the oxygen concentration. It may also be permissible, after sintering in an inert atmosphere, to control the oxygen amount of a sintered body by performing annealing in an oxidizing atmosphere.

A mixture of $CaMnO_3$ and CuO may also be produced by calcining a mixture of a raw material of $CaMnO_3$ which is capable of becoming $CaMnO_3$ by calcination and a raw material of CuO which is capable of becoming CuO by calcination (corresponding to the above-described case (d)). The calcination may be carried out by keeping at a calcining temperature of from 600°C to 1100°C for 0 to 24 hours in an oxidizing atmosphere.

The sintered body obtained as described above is superior in mechanical strength, and further, superior also in thermal shock resistance and has light weight. Since its thermoelectric converting property as a thermoelectric conversion material is not deteriorated, a thermoelectric conversion material composed of this sintered body is very useful for a thermoelectric converting device. For a thermoelectric converting device, conventional techniques as disclosed in, for example, JP-A No. 5-315657 may be used. In a thermoelectric converting device, a p-type thermoelectric conversion material and an n-type thermoelectric conversion material may be used in combination, and it may also be permissible that a thermoelectric conversion material of the present invention is used in any one of a p-type thermoelectric conversion material and an n-type thermoelectric conversion material and conventional techniques are used in another material.

The efficiency of converting thermal energy into electric energy of a thermoelectric conversion material (hereinafter, referred to as "energy conversion efficiency" in some cases) depends on the performance index (Z) of a thermoelectric conversion material. The performance index (Z) is determined according to the following formula (2) using the Seebeck coefficient ($\alpha$), the electric conductivity ($\sigma$) and the thermal conductivity ($\kappa$) of a thermoelectric conversion material. A thermoelectric conversion material having larger performance index (Z) is said to be a thermoelectric converting device superior in energy conversion efficiency. Particularly, $\alpha^2 \times \sigma$ in the formula (2) is called power factor (PF). A thermoelectric conversion material having larger PF value is said to be a thermoelectric converting device superior in output per unit temperature.

$$Z = \alpha^2 \times \sigma / \kappa \quad (2)$$

Here, the unit of Z is 1/K, the unit of $\alpha$ is V/K, the unit of $\sigma$ is S/m and the unit of k is W/(m·K).

EXAMPLES

The present invention will be illustrated further in detail by examples below. For evaluation of the structure of a sintered body, its strength, and properties as a thermoelectric conversion material, methods shown below were used.

1. Structure analysis

The crystal structure of sintered body specimens was analyzed by a powder X-ray diffraction method using a CuK$\alpha$ radiation source, using an X-ray diffractometer RINT2500TTR type manufactured by Rigaku Corporation.

2. Bending strength

A rod-shaped sintered body having a width (w) of $4\pm1$ mm, a thickness (t) of $3\pm1$ mm and a length of 36 mm or more was fabricated, and a three point bending test was carried out using SHIKIBU manufactured by Shimadzu Corp. A distance (L) between supporting points was 30 mm, and the cross head speed was 0.5 mm/min.

Bending strength ($\delta$) was determined according to the following formula:

$$\delta = 3PL/2wt^2$$

wherein P represents maximum load (N) in breaking of a specimen piece, and the unit of $\delta$ is N/ mm$^2$.

Seven or more samples were measured for each specimen and data was determined, and the average value ($\delta_{ave}$) was determined excluding the maximum data and the minimum data.

3. Thermoelectric converting properties

Electric conductivity ($\sigma$)

A sintered body specimen was processed into a rectangular cylinder shape, a platinum line was bonded thereto with a silver paste, and then the electric conductivity ($\sigma$) was measured by a direct current four-terminal method. The measurement was carried out while changing the temperature in the range from room temperature to 1073 K in a nitrogen gas flow. The unit of $\sigma$ was S/m.

Seebeck coefficient ($\alpha$)

An R-type thermocouple (composed of platinum-rhodium line and platinum line) was, with a silver paste, bonded on the both end surfaces of a sintered body specimen processed into the same shape as in measurement of electric conductivity, and the temperatures of the both end surfaces of the sintered body specimen and thermoelectromotive forces were measured. The measurement was carried out while changing the temperature in the range from room temperature to 1073 K in a nitrogen gas flow. A glass tube in which air was flowing was allowed to make a contact with the one end surface of the sintered body specimen to male a low temperature part, the temperatures of the both end surfaces of the sintered body specimen were measured by the R-type thermocouple, and simultaneously, the thermo-electromotive force ($\Delta V$) generated between the both end surfaces of the sintered body specimen was measured by a platinum line of the R-type thermocouple. The temperature difference ($\Delta T$) between the both ends of the sintered body specimen was controlled in the range of 1 to 10°C by controlling the flow rate of air flowing in the glass tube, and the Seebeck coefficient ($\alpha$) was determined from the inclinations of $\Delta T$ and $\Delta V$. The unit of $\alpha$ was V/K.

Thermal conductivity ($\kappa$)

Measurement of the thermal conductivity of a sintered body specimen was carried out while changing the temperature within the range of from room temperature to 600°C in vacuum by a laser flash method. For measurement, a laser flash thermal constants analyzer TC-7000 type manufactured by ULVAC-RIKO, Inc. was used.

Performance index (Z)

The value of Z was calculated according to the above-described formula (2) from the above-described values of $\sigma$, $\alpha$ and $\kappa$.

Comparative Example 1 (manganese-based oxide only)

$CaCO_3$ (manufactured by Ube Material Industries, CS3N-A (trade name)) of 8.577 g, $MnO_2$ (manufactured by Kojundo Chemical Laboratory) of 7.852 g and $MoO_3$ (manufactured by Kojundo Chemical Laboratory) of 0.247 g were weighed out, then mixed for 20 hours by a wet ball mill using zirconia balls, and calcined by keeping at 900°C for 10 hours in air. The resultant calcined substance was pulverized for 20 hours by a wet ball mill using zirconia balls, and then molded into a rod shape by a uniaxial press (molding pressure: 500 kg/cm$^2$). The resultant molded body was sintered by keeping at 1300°C for 10 hours in air to yield Sintered body 1. Sintered body 1 had a relative density of 96.0%. Powder X-ray diffractometry revealed that Sintered body 1 had the same crystal structure as a perovskite type crystal of $CaMnO_3$.

Reference Example 1 (manganese-based oxide + copper oxide)

A molded body was fabricated in the same manner as in Comparative Example 1 excepting that $CaCO_3$ (manufactured by Ube Material Industries, CS3N-A (trade name)) of 8.577 g, $MnO_2$ (manufactured by Kojundo Chemical Laboratory) of 7.852 g, $MoO_3$ (manufactured by Kojundo Chemical Laboratory) of 0.247 g and CuO (manufactured by Kojundo Chemical Laboratory) of 4.545 g were used. The resultant molded body was sintered by keeping at 1050°C for 10 hours in air to yield Sintered body 2. Sintered body 2 had a relative density of 99%. Powder X-ray diffractometry revealed that Sintered body 2 had the same crystal structure as a perovskite type crystal of $CaMnO_3$ and a crystal structure of CuO. This could confirm that CuO and a manganese-based oxide did not react easily in Sintered Body 2.

Example 1 (manganese-based oxide + copper oxide)

$CaCO_3$ (manufactured by Ube Material Industries, CS3N-A (trade name)) of 8.577 g, $MnO_2$ (manufactured by Kojundo Chemical Laboratory) of 7.852 g, $MoO_3$ (manufactured by Kojundo Chemical Laboratory) of 0.247 g and CuO (manufactured by Kojundo Chemical Laboratory) of 0.359 g (the ratio of the molar amount of the copper oxide to one mol of a manganese-based oxide is 0.05) were weighed out, then mixed for 20 hours by a wet ball mill using zirconia balls, and calcined by keeping at 900°C for 10 hours in air. The resultant mixture of a manganese-based oxide and copper oxide was pulverized for 20 hours by a wet ball mill using zirconia balls, and then molded by a uniaxial press (molding pressure: 500 kg/cm$^2$). The resultant molded body was subjected to a CIP treatment (pressure: 1000 kg/cm$^2$), then, the resultant molded body was sintered by further keeping at 980°C for 10 hours in air to yield Sintered body 3.
Sintered body 3 had a relative density of 86.6%. Powder X-ray diffractometry of Sintered body 3 revealed detection of a peak of the same crystal structure as a perovskite type crystal of $CaMnO_3$. In powder X-ray diffractometry of Sintered body 3, the crystal structure of CuO could not be confirmed. This is ascribable to small amount of CuO, and the results of Reference Example 1 indicate the presence of CuO also in Sintered body 3.

Based on these facts, the main component of Sintered body 3 was found to be a manganese-based oxide. The bending strength ($N/mm^2$) in a three-point bending test of Sintered body 3 was 376 when that of Sintered body 1 was 100. The thermoelectric converting property (Z) of Sintered body 3 was approximately the same as that of Sintered body 1.

Example 2 (manganese-based oxide + copper oxide)

Sintered body 4 was fabricated in the same manner as in Example 1 excepting that sintering was carried out by keeping at 960°C for 10 hours. Sintered body 4 had a relative density of 84.0%. Powder X-ray diffractometry of Sintered body 4 revealed detection of a peak of the same crystal structure as a perovskite type crystal of $CaMnO_3$. In powder X-ray diffractometry of Sintered body 4, the crystal structure of CuO could not be confirmed. This is ascribable to small amount of CuO, and the results of Reference Example 1 indicate the presence of CuO also in Sintered body 4. Based on these facts, the main component of Sintered body 4 was found to be a manganese-based oxide. The bending strength ($N/mm^2$) in a three-point bending test of Sintered body 3 was 293 when that of Sintered body 1 was 100. The thermoelectric converting property (Z) of Sintered body 4 was approximately the same as that of Sintered body 1.

Comparative Example 2 (manganese-based oxide)

A molded body was fabricated in the same manner as in Example 1 excepting that CuO was not used. The resultant molded body was sintered by keeping at 1150°C for 10 hours in air to yield Sintered body 5. Sintered body 5 had a relative density of 87.7%. Powder X-ray diffractometry of Sintered body 5 revealed detection of a peak of the same crystal structure as a perovskite type crystal of $CaMnO_3$. The bending strength ($N/mm^2$) in a three-point bending test of Sintered body 5 was 84 when that of Sintered body 1 was 100.

INDUSTRIAL APPLICABILITY

According to the present invention, a sintered body superior in mechanical strength as compared with conventional manganese-based oxide sintered bodies can be provided, without deteriorating properties as a thermoelectric conversion material. The sintered body of the present invention is superior also in thermal shock resistance, additionally, has light weight, thus, a light and tough thermoelectric conversion material can be realized, and the sintered body is extremely suitable for a thermoelectric converting device. A thermoelectric converting device comprising a thermoelectric conversion material composed of the sintered body of the present invention can be suitably used for thermoelectric converting electric generation utilizing waste heat of factories, waste heat of incinerators, waste heat of factory furnaces, waste heat of automobiles, underground heat, solar heat and the like, and can also be used for precise temperature controlling apparatuses for laser diodes and the like, air conditioning equipments, refrigerators and the like. The sintered body of the present invention can be used also for solid oxides for fuel cells, magnetic materials, and the like, in addition to thermoelectric conversion materials.

**Claims**

1. A sintered body comprising a manganese-based oxide as a main component, further comprising an oxide A wherein the oxide A represents one or more members selected from among nickel oxides, copper oxide and zinc oxide, and having a relative density of 80% or more and 90% or less.

2. The sintered body according to Claim 1, wherein the manganese-based oxide has a perovskite type crystal structure or a layered perovskite type crystal structure.

3. The sintered body according to Claim 1 or 2, wherein the manganese-based oxide comprises calcium.

4. The sintered body according to any one of Claims 1 to 3, wherein the oxide A is copper oxide.

5. The sintered body according to Claim 4, wherein the ratio of the molar amount of the copper oxide to one mol of the manganese-based oxide is 0.0001 or more and 0.25 or less.

6. A thermoelectric conversion material composed of the sintered body according to any one of Claims 1 to 5.

7. A thermoelectric converting device comprising the thermoelectric conversion material according to Clam 6.

## INTERNATIONAL SEARCH REPORT

| | International application No. |
|---|---|
| | PCT/JP2009/057714 |

A.   CLASSIFICATION OF SUBJECT MATTER
*H01L35/22*(2006.01)i, *C04B35/00*(2006.01)i

According to International Patent Classification (IPC) or to both national classification and IPC

B.   FIELDS SEARCHED

Minimum documentation searched (classification system followed by classification symbols)
H01L35/22, C04B35/00

Documentation searched other than minimum documentation to the extent that such documents are included in the fields searched
Jitsuyo Shinan Koho          1922-1996    Jitsuyo Shinan Toroku Koho    1996-2009
Kokai Jitsuyo Shinan Koho    1971-2009    Toroku Jitsuyo Shinan Koho    1994-2009

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| Y | JP 2005-51103 A (Japan Science and Technology Agency), 24 February, 2005 (24.02.05), Claims; example 2; Par. No. [0030] (Family: none) | 1-7 |
| Y | JP 2003-142742 A (Toyota Central Research and Development Laboratories, Inc.), 16 May, 2003 (16.05.03), Claims; Par. Nos. [0031], [0059] (Family: none) | 1-7 |
| A | JP 2007-335504 A (Sumitomo Chemical Co., Ltd.), 27 December, 2007 (27.12.07), Claims; Par. Nos. [0014], [0027] (Family: none) | 1-7 |

| ☒ | Further documents are listed in the continuation of Box C. | ☐ | See patent family annex. |

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 30 June, 2009 (30.06.09) | 07 July, 2009 (07.07.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2009/057714

C (Continuation).   DOCUMENTS CONSIDERED TO BE RELEVANT

| Category* | Citation of document, with indication, where appropriate, of the relevant passages | Relevant to claim No. |
|---|---|---|
| A | WO 2006/109884 A1  (Sumitomo Chemical Co., Ltd.), 19 October, 2006 (19.10.06), Claims; page 7, lines 5 to 9 & JP 2006-294960 A      & EP 1895603 A1 & KR 10-2008-0003875 A   & CN 101156256 A | 1-7 |
| P,X | WO 2008/047885 A1  (Sumitomo Chemical Co., Ltd.), 24 April, 2008 (24.04.08), Claims & JP 2008-124417 A | 1-7 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003142742 A
- JP 5315657 A